# EUROPEAN PATENT APPLICATION

(11) **EP 4 592 261 A1**
(43) Date of publication of application: **30.07.2025**
(21) Application number: 23870025.6
(22) Date of filing: 16.08.2023
(51) Int. Cl.: C03C 17/42, C04B 41/89, C08J 7/04, H05K 5/00

(54) **IMITATION CERAMIC STRUCTURE, PREPARATION METHOD THEREFOR, AND ELECTRONIC DEVICE HOUSING**

(30) Priority: 26.09.2022 CN 202211176255
(71) Applicant: BYD Company Limited, Shenzhen, Guangdong 518118 (CN)
(72) Inventor: LI, Chao, Shenzhen, Guangdong 518118 (CN); LIU, Yuyang, Shenzhen, Guangdong 518118 (CN); MA, Lan, Shenzhen, Guangdong 518118 (CN)
(74) Representative: Taor, Simon Edward William
(86) International application number: PCT/CN2023/113298
(87) International publication number: WO 2024/066779

(57) **Abstract**

An imitation ceramic structure, which comprises a transparent base material, an imitation ceramic film layer, and an ink layer; the imitation ceramic film layer is located between the transparent base material and the ink layer, and the imitation ceramic film layer is made of a first high-refractive-index material layer, a first low-refractive-index material layer, a second high-refractive-index material layer, and a second low-refractive-index material layer; and the first high-refractive-index material layer, the first low-refractive-index material layer, the second high-refractive-index material layer, and the second low-refractive-index material layer are stacked in sequence. Additionally, the present application further discloses a preparation method for the imitation ceramic structure and an electronic device housing comprising the imitation ceramic structure.

## Description

### CROSS-REFERENCE TO RELATED APPLICATIONS

This application claims priority to and benefits of Chinese Patent Application No. 202211176255.4, filed on September 26, 2022. The entire content of the above-referenced application is incorporated herein by reference.

### FIELD

The present disclosure relates to the field of electronic device housing technologies, and specifically to a ceramic-like structure, a preparation method therefor, and an electronic device housing.

### BACKGROUND

At present, there is a technology that forms an ceramic-like effect the glass back cover through a coating process or a combination of a film and a coating process. However, regardless of whether a coating process or the combination of a film and a coating process is used, the obtain color effect is mainly glittering, gradient, or monochromatic, and often has no tactile appeal. On the one hand, the reflectivity of a ceramic-like glass back cover obtained by a conventional process to light is still different from that of a ceramic back cover. On the other hand, a ceramic-like glass back cover obtained by a conventional process may present a real ceramic-like effect when observed from the front, but once the observation angle or the angle of incidence of light is changed, the color of the glass back cover obtained by such process will change greatly. In contrast, the color of a real ceramic back cover is relatively uniform when observed at different angles, and does not change as the conventional ceramic-like glass back cover does. The main reasons are as follows. Conventional coating processes have a certain degree of visual color change (where the visual effect of the color varies with different observation angles). In addition, some ceramic-like glass back covers are also provided with an ultraviolet (UV) texture layer to achieve a ceramic-like effect on the front side, but the UV texture layer also has the problem of color change with the change of observation angle. Therefore, conventional ceramic-like glass back covers have not achieved a real ceramic-like effect.

### SUMMARY

To solve the problem that conventional ceramic-like glass back covers cannot provide a real ceramic-like effect, the present disclosure provides a ceramic-like structure, a preparation method therefor, and an electronic device housing.

To solve the above technical problems, the following technical schemes are employed in the present disclosure.

According to one aspect, the present disclosure provides a ceramic-like structure, including:
a transparent substrate;
an ink layer; and
a ceramic-like film layer, the ceramic-like film layer being located between the transparent substrate and the ink layer, the ceramic-like film layer being formed by a first high-refractive-index material layer, a first low-refractive-index material layer, a second high-refractive-index material layer, and a second low-refractive-index material layer, and the first high-refractive-index material layer, the first low-refractive-index material layer, the second high-refractive-index material layer, and the second low-refractive-index material layer being stacked in sequence; and
refractive indexes of the first high-refractive-index material layer and the second high-refractive-index material layer being greater than 2.3, and refractive indexes of the first low-refractive-index material layer and the second low-refractive-index material layer being less than 1.6.

Optionally, a reflectivity of the ceramic-like structure ranges from 25% to 30%.

Optionally, the first high-refractive-index material layer is in contact with the transparent substrate.

Optionally, the first low-refractive-index material layer and the second low-refractive-index material layer are each independently selected from one or more of SiO₂ and MgF₂.

Optionally, the first low-refractive-index material layer and the second low-refractive-index material layer are selected from SiO₂.

Optionally, the first high-refractive-index material layer and the second high-refractive-index material layer are each independently selected from one or more of Nb₂O₅, Ti₃O₅, and TiO₂.

Optionally, the first high-refractive-index material layer and the second high-refractive-index material layer are selected from Nb₂O₅.

Optionally, a thickness of the first high-refractive-index material layer ranges from 53.8 nm to 105.8 nm, a thickness of the second high-refractive-index material layer ranges from 1 nm to 16 nm, a thickness of the first low-refractive-index material layer ranges from 32.4 nm to 86.4 nm, and a thickness of the second low-refractive-index material layer ranges from 44.6 nm to 90.6 nm.

Optionally, the transparent substrate is glass.

Optionally, the ceramic-like structure further includes a drop-resistant layer, the drop-resistant layer is located between the transparent substrate and the ceramic-like film layer, and the drop-resistant layer is an organosiloxane material.

Optionally, the organosiloxane material is obtained by polymerization of a low-molecular-weight siloxane, the low-molecular-weight siloxane includes one or more of a dialkoxysilane containing an organic group, a trialkoxysilane containing an organic group, and a tetraalkoxysilane, and the organic group is selected from the group consisting of an alkyl group, a phenyl group, an epoxy group, an amino group, an isocyanate group, an ester group, and combinations thereof.

Optionally, a thickness of the drop-resistant layer ranges from 100 nm to 2000 nm.

According to another aspect, the present disclosure provides a method for preparing the ceramic structure described above, including the following operations:
providing a transparent precursor including the transparent substrate;
coating the first high-refractive-index material layer, the first low-refractive-index material layer, the second high-refractive-index material layer, and the second low-refractive-index material layer on the transparent precursor in sequence to form the ceramic-like film layer on a surface of the transparent precursor; and
applying an ink to a surface of the formed ceramic-like film layer to obtain the ceramic-like structure.

Optionally, a surface of the transparent substrate is covered with a silicate-based material to form a drop-resistant layer to obtain the transparent precursor; and the ceramic-like film layer is formed on a surface of the drop-resistant layer.

Optionally, before the drop-resistant layer is formed, the transparent substrate is subjected to surface cleaning treatment.

Optionally, the first high-refractive-index material layer, the first low-refractive-index material layer, the second high-refractive-index material layer, and the second low-refractive-index material layer are coated on the transparent precursor in sequence by vacuum coating.

According to another aspect, the present disclosure provides an electronic device housing, including the ceramic-like structure described above,

According to the ceramic-like structure provided in the present disclosure, it is found through a large number of experiments that by using a specific number and order of the first high-refractive-index material layer, the first low-refractive-index material layer, the second high-refractive-index material layer, and the second low-refractive-index material layer between the transparent substrate and the ink layer to form the ceramic-like film layer, a ceramic-like effect can be realized on the surface of the transparent substrate, so that ceramics can be replaced to a certain extent. In addition, the material and processing costs of the conventional transparent substrate are low, so the production cost can be effectively reduced. In particular, compared with conventional ceramic-like structures, the ceramic-like structure obtained by the present disclosure has a surface reflectivity similar to that of an existing real ceramic structure, and its color does not change with the observation angle. When the ceramic-like structure is observed at different observation angles under light incident at different angles, the color difference observed is small and there is visually no color change effect. Therefore, the ceramic-like structure obtained by the present disclosure can better simulate the real tactile appeal of a ceramic structure.

### BRIEF DESCRIPTION OF THE DRAWINGS

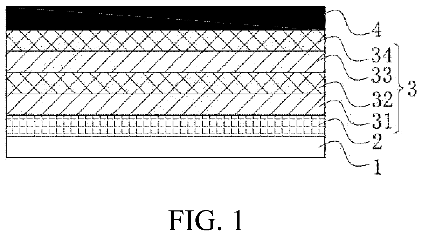

FIG. 1 is a schematic structural diagram of a ceramic-like structure according to the present disclosure.

List of reference numerals:
1. transparent substrate; 2. drop-resistant layer; 3. ceramic-like film layer; 31. first high-refractive-index material layer; 32. first low-refractive-index material layer; 33. second high-refractive-index material layer; 34. second low-refractive-index material layer; 4. ink layer.

### DETAILED DESCRIPTION

To make the technical problems to be solved by the present disclosure, technical solutions, and beneficial effects more comprehensible, the following further describes the present disclosure in detail with reference to the accompanying drawings and examples. It should be understood that the specific examples described herein are merely used for explaining the present disclosure, and are not intended to limit the present disclosure.

Referring to FIG. 1, an example of the present disclosure provides a ceramic-like structure, including a transparent substrate 1, a ceramic-like film layer 3, and an ink layer 4. The ceramic-like film layer 3 is located between the transparent substrate 1 and the ink layer 4. The ceramic-like film layer 3 is formed by a first high-refractive-index material layer 31, a first low-refractive-index material layer 32, a second high-refractive-index material layer 33, and a second low-refractive-index material layer 34. The first high-refractive-index material layer 31, the first low-refractive-index material layer 32, the second high-refractive-index material layer 33, and the second low-refractive-index material layer 34 are stacked in sequence.

Refractive indexes of the first high-refractive-index material layer 31 and the second high-refractive-index material layer 33 are greater than 2.3, and refractive indexes of the first low-refractive-index material layer 32 and the second low-refractive-index material layer 34 are less than 1.6.

It is found through a large number of experiments that by using a specific number and order of the first high-refractive-index material layer 31, the first low-refractive-index material layer 32, the second high-refractive-index material layer 33, and the second low-refractive-index material layer 34 between the transparent substrate 1 and the ink layer 4 to form the ceramic-like film layer 3, a ceramic-like effect can be realized on the surface of the transparent substrate 1, so that ceramics can be replaced to a certain extent. In addition, the material and processing costs of the conventional transparent substrate 1 are low, so the production cost can be effectively reduced. In particular, compared with conventional ceramic-like structures, the ceramic-like structure obtained by the present disclosure has a surface reflectivity similar to that of an existing real ceramic structure, and its color does not change with the observation angle. When the ceramic-like structure is observed at different observation angles under light incident at different angles, the color difference observed is small and there is visually no color change effect. Therefore, the ceramic-like structure obtained by the present disclosure can better simulate the real tactile appeal of a ceramic structure.

It should be noted that the terms "first high-refractive-index material layer 31", "second high-refractive-index material layer 33", "first low-refractive-index material layer 32", and "second low-refractive-index material layer 34" are relative concepts, indicating that the refractive indexes of the "first high-refractive-index material layer 31" and the "second high-refractive-index material layer 33" are higher than those of the "first low-refractive-index material layer 32" and the "second low-refractive-index material layer 34".

The stack of the high-refractive-index material layers and the low-refractive-index material layers can adjust the reflection of light, and has an impact on the surface glossiness of the ceramic-like structure together with the transparent substrate 1 and the ink layer 4. It should be noted that different numbers and orders of high-refractive-index material layers and low-refractive-index material layers in the stack have a great impact on the glossiness and reflectivity in different directions. In the present disclosure, the characteristic of small color difference of the ceramic-like structure under light incident at different angles and under different observation conditions is directly related to the number and order of high-refractive-index material layers and low-refractive-index material layers in the stack, and any change in the number and order of high-refractive-index material layers and low-refractive-index material layers in the stack will lead to a change in the presentation effect, resulting in that a tactile appeal of real ceramics to be realized in the present disclosure cannot be obtained.

In some examples, a reflectivity of the ceramic-like structure ranges from 25% to 30%.

Controlling the surface reflectivity of the ceramic-like structure to be range from 25% and 30% can better simulate the gloss of ceramics and meet the requirements of simulating ceramics. Specifically, the reflectivity of the ceramic-like film layer 3 can be adjusted by selecting the refractive indexes of the first high-refractive-index material layer 31, the second high-refractive-index material layer 33, the first low-refractive-index material layer 32, and the second low-refractive-index material layer 34 and controlling the film thickness.

In some examples, the first high-refractive-index material layer 31 is in contact with the transparent substrate, i.e., the first high-refractive-index material layer 31, the first low-refractive-index material layer 32, the second high-refractive-index material layer 33, and the second low-refractive-index material layer 34 are stacked in sequence in a direction away from the transparent substrate 1. Alternatively, the second low-refractive-index material layer 34 is in contact with the transparent substrate, i.e., the first high-refractive-index material layer 31, the first low-refractive-index material layer 32, the second high-refractive-index material layer 33, and the second low-refractive-index material layer 34 are stacked in sequence in a direction away from the ink layer 4.

In addition, compared with the case where "the second low-refractive-index material layer 34 is in contact with the transparent substrate", arranging the first high-refractive-index material layer 31 to be in contact with the transparent substrate helps improve the bonding force between the film layers, so as to improve the wear resistance of the ceramic-like structure.

In some examples, the first low-refractive-index material layer 32 and the second low-refractive-index material layer 34 are each independently selected from at least one of SiO₂ and MgF₂.

In some examples, the first low-refractive-index material layer 32 and the second low-refractive-index material layer 34 are selected from SiO₂.

In some examples, the first high-refractive-index material layer 31 and the second high-refractive-index material layer 33 are each independently selected from at least one of Nb₂O₅, Ti₃O₅, and TiO₂.

In some examples, the first high-refractive-index material layer 31 and the second high-refractive-index material layer 33 are selected from Nb₂O₅.

In some examples, a thickness of the first high-refractive-index material layer 31 ranges from 53.8 nm to 105.8 nm, a thickness of the second high-refractive-index material layer 33 ranges from 1 nm to 16 nm, a thickness of the first low-refractive-index material layer 32 ranges from 32.4 nm to 86.4 nm, and a thickness of the second low-refractive-index material layer 34 ranges from 44.6 nm to 90.6 nm.

The thicknesses of the first high-refractive-index material layer 31, the second high-refractive-index material layer 33, the first low-refractive-index material layer 32, and the second low-refractive-index material layer 34 have a large impact on the ceramic-like effect of the ceramic-like structure. When the thicknesses of the first high-refractive-index material layer 31, the second high-refractive-index material layer 33, the first low-refractive-index material layer 32, and the second low-refractive-index material layer 34 are respectively in the above ranges, the consistency between the surface reflectivity of the ceramic-like structure and the real ceramic effect can be ensured, and the problem of display difference caused by excessively small or large thicknesses can be avoided.

In some examples, the transparent substrate 1 may be a single layer of transparent material or a stack of multiple layers of transparent materials.

The shape of the ceramic-like structure is mainly determined by the structure of the transparent substrate 1. The shape of the transparent substrate 1 may be adjusted according to different application fields. For example, the transparent substrate 1 may be in the shape of a plate, a three-dimensional structure, or an irregular structure, and its size may be selected according to an actual situation. For example, when the ceramic-like structure is a backplane of a mobile phone, the area and thickness of the ceramic-like structure may be adjusted according to the specific shape of the mobile phone.

In some examples, the transparent substrate 1 is at least one of a transparent plastic material and glass.

In some examples, the transparent substrate 1 is glass.

Compared with using the transparent plastic material as the transparent base material 1, using glass as the transparent base material 1 has the characteristics of high hardness, high transparency, and low haze, and can better present the tactile quality and glaze texture similar to ceramics.

In some examples, the ceramic-like structure further includes a drop-resistant layer 2, the drop-resistant layer 2 is located between the transparent substrate 1 and the ceramic-like film layer 3, and the drop-resistant layer 2 is an organosiloxane material.

The organosiloxane material has good deformation adaptability, and microcracks on the glass can be filled by using the organosiloxane material as the drop-resistant layer 2 between the glass and the ceramic-like film layer 3, so as to reinforce the glass and improve the impact resistance of the glass. In addition, the drop-resistant layer 2 can well buffer the stress produced by the ceramic-like film layer 3, to solve the problem of stress mismatch between the ceramic-like layer and the glass, and effectively improve the strength and impact resistance of the ceramic-like structure.

In some examples, the organosiloxane material is obtained by polymerization of a low-molecular-weight siloxane, the low-molecular-weight siloxane includes one or more of a dialkoxysilane containing an organic group, a trialkoxysilane containing an organic group, and a tetraalkoxysilane, and the organic group is selected from the group consisting of an alkyl group, a phenyl group, an epoxy group, an amino group, an isocyanate group, an ester group, and combinations thereof.

The drop-resistant layer 2 may be obtained by vapor deposition on the transparent substrate 1 using an organosiloxane as a target material, or may be obtained by directly coating the transparent substrate 1 with a low-molecular-weight siloxane followed by polymerization and curing.

In some examples, a thickness of the drop-resistant layer 2 ranges from 100 nm to 2000 nm.

When the thickness of the drop-resistant layer 2 is in the above range, a good buffering effect can be provided to improve the impact resistance of the ceramic-like structure, and the thickness of the drop-resistant layer 2 can be prevented from being too large to affect the optical display effect of the ceramic-like structure.

In some examples, the ink layer 4 may be an ink layer of different colors. For example, the ink layer 4 may be red, yellow, blue, green, black, or a mixture thereof.

In some examples, the ink layer 4 is black.

In some examples, the ceramic-like structure may also include other functional layers that do not affect its ceramic-like effect, such as a hardened layer, an anti-fingerprint layer, and the like.

Another example of the present disclosure provides a method for preparing the ceramic structure described above, including the following operations.

A transparent precursor including the transparent substrate 1 is provided.

The first high-refractive-index material layer 31, the first low-refractive-index material layer 32, the second high-refractive-index material layer 33, and the second low-refractive-index material layer 34 are coated on the transparent precursor in sequence to form the ceramic-like film layer 3 on a surface of the transparent precursor.

An ink is applied to a surface of the formed ceramic-like film layer 3 to obtain the ceramic-like structure.

In some examples, a surface of the transparent substrate 1 is covered with a silicate-based material to form a drop-resistant layer 2 to obtain the transparent precursor; and the ceramic-like film layer 3 is formed on a surface of the drop-resistant layer 2.

In some examples, before the drop-resistant layer 2 is formed, the transparent substrate 1 is subjected to surface cleaning treatment.

The surface cleaning treatment of the transparent substrate 1 includes one or more of cleaning with deionized water, cleaning with a surfactant, and ultrasonic cleaning.

The surface cleaning treatment is beneficial to remove impurities such as dust on the surface of the transparent substrate 1, to prevent the impurities on the surface of the transparent substrate 1 from affecting the bonding effect and optical properties of the ceramic-like film layer 3.

In some examples, the first high-refractive-index material layer 31, the first low-refractive-index material layer 32, the second high-refractive-index material layer 33, and the second low-refractive-index material layer 34 are coated on the transparent precursor in sequence by vacuum coating.

The first high-refractive-index material layer 31, the first low-refractive-index material layer 32, the second high-refractive-index material layer 33, and the second low-refractive-index material layer 34 may be prepared by physical vapor deposition, evaporation coating, or magnetron sputtering.

Specifically, depending on the selected material, the corresponding target material may be bombarded by an ion source to form a sputtering source for deposition in a vacuum or inert gas environment, and an auxiliary gas source such as oxygen or nitrogen may be added if necessary. For example, when the first low-refractive-index material layer 32 and the second low-refractive-index material layer 34 are selected from SiO₂, silicon may be used as the target material, and oxygen may be introduced as an auxiliary gas to form the SiO₂ layers. When the first high-refractive-index material layer 31 and the second high-refractive-index material layer 33 are selected from Nb₂O₅, metal niobium may be used as the target material, and oxygen may be introduced as an auxiliary gas to form the Nb₂O₅ layers.

In some examples, the ink layer 4 may be prepared by spray coating, shower coating, roll coating, or screen printing.

Another example of the present disclosure provides an electronic device housing, including the ceramic-like structure described above.

In some examples, the electronic device housing is a mobile phone, a tablet computer, a watch, or other wearable electronic devices, or a household appliance.

The present disclosure is further described below with reference to examples.

### Example 1

This example is used to describe the ceramic-like structure and the preparation method therefor disclosed in the present disclosure, including the following operations.

### 1) Cleaning:

A glass substrate was cleaned in a nine-cell ultrasonic cleaner for 1 hour to remove dust and dirt residues on the surface of the glass substrate.

### 2) Coating of a drop-resistant layer:

a. A part of the cleaned glass substrate that was not to be treated was covered with a protective film, and then the cleaned glass substrate was fixed to an umbrella of a coating machine to complete the feeding.
b. The coating machine was turned on to coat a drop-resistant layer on the glass substrate by vapor deposition using an organosiloxane as a film material.

### 3) Coating of a ceramic-like film:

SiO₂ was obtained through coating by sputtering a Si target. Nb₂O₅ was obtained by sputtering a Nb target.
a. The glass substrate was placed on a fixture of a sputtering machine and vacuuming was performed.
b. When a vacuum degree of a coating chamber reached 3×10⁻³ Pa, Ar gas was introduced, and stabilized.
c. An ion source was turned on, supply of oxygen for the ion source was started, and at the same time, a sputtering power supply for a Nb target was turned on with a power of 10 KW, and a thickness was set to 54.8 nm, thus completing the coating of Nb₂O₅.
d. The sputtering power supply for the Nb target was turned off, a sputtering power supply for a Si target was turned on, and oxygen was supplied at 150 sccm, to deposit a SiO₂ film layer having a thickness of 84.4 nm, thus completing the coating.
e. The sputtering power supply for the Si target was turned off, the sputtering power supply for the Nb target was turned on, and oxygen was supplied at 200 sccm, to deposit a Nb₂O₅ film layer having a thickness of 9 nm, thus completing the coating.
f. The sputtering power supply for the Nb target was turned off, the sputtering power supply for the Si target was turned on, and oxygen was supplied at 150 sccm, to deposit a SiO₂ film layer having a thickness of 45.6 nm, thus completing the coating.
g. After the coating was completed, the sputtering power supply for the Si target was turned off, and the power supply for the ion source was turned off. Then, supply of argon and supply of oxygen were turned off, the rotation of the rotating frame was stopped, and after the workpiece was cooled down, a freezer was started to defrost. Finally, air was introduced to the coating chamber so that the pressure in the coating chamber reached atmospheric pressure, and then the coated glass substrate was taken out.

4) The coated glass substrate was silk-screened with a black ink and baked at 120°C for 90 minutes.

### Example 2

This example is used to describe the ceramic-like structure and the preparation method therefor disclosed in the present disclosure, including most of the steps in Example 1 with the following differences.

### 3) In the coating of the ceramic-like film:

SiO₂ was obtained through coating by sputtering a Si target. Nb₂O₅ was obtained by sputtering a Nb target.
a. The glass substrate was placed on a fixture of a sputtering machine and vacuuming was performed.
b. When a vacuum degree of a coating chamber reached 3×10⁻³ Pa, Ar gas was introduced, and stabilized.
c. An ion source was turned on, supply of oxygen for the ion source was started, and at the same time, a sputtering power supply for a Nb target was turned on with a power of 10 KW, and a thickness was set to 95.3 nm, thus completing the coating of Nb₂O₅.
d. The sputtering power supply for the Nb target was turned off, a sputtering power supply for a Si target was turned on, and oxygen was supplied at 150 sccm, to deposit a SiO₂ film layer having a thickness of 35.1 nm, thus completing the coating.
e. The sputtering power supply for the Si target was turned off, the sputtering power supply for the Nb target was turned on, and oxygen was supplied at 200 sccm, to deposit a Nb₂O₅ film layer having a thickness of 2.7 nm, thus completing the coating.
f. The sputtering power supply for the Nb target was turned off, the sputtering power supply for the Si target was turned on, and oxygen was supplied at 150 sccm, to deposit a SiO₂ film layer having a thickness of 87.7 nm, thus completing the coating.
g. After the coating was completed, the sputtering power supply for the Si target was turned off, and the power supply for the ion source was turned off. Then, supply of argon and supply of oxygen were turned off, the rotation of the rotating frame was stopped, and after the workpiece was cooled down, a freezer was started to defrost. Finally, air was introduced to the coating chamber so that the pressure in the coating chamber reached atmospheric pressure, and then the coated glass substrate was taken out.

### Example 3

This example is used to describe the ceramic-like structure and the preparation method therefor disclosed in the present disclosure, including most of the steps in Example 1 with the following differences.

### 3) In the coating of the ceramic-like film:

SiO₂ was obtained through coating by sputtering a Si target. Nb₂O₅ was obtained by sputtering a Nb target.
a. The glass substrate was placed on a fixture of a sputtering machine and vacuuming was performed.
b. When a vacuum degree of a coating chamber reached 3×10⁻³ Pa, Ar gas was introduced, and stabilized.
c. An ion source was turned on, supply of oxygen for the ion source was started, and at the same time, a sputtering power supply for a Nb target was turned on with a power of 10 KW, and a thickness was set to 84.2 nm, thus completing the coating of Nb₂O₅.
d. The sputtering power supply for the Nb target was turned off, a sputtering power supply for a Si target was turned on, and oxygen was supplied at 150 sccm, to deposit a SiO₂ film layer having a thickness of 34.5 nm, thus completing the coating.
e. The sputtering power supply for the Si target was turned off, the sputtering power supply for the Nb target was turned on, and oxygen was supplied at 200 sccm, to deposit a Nb₂O₅ film layer having a thickness of 15.3 nm, thus completing the coating.
f. The sputtering power supply for the Nb target was turned off, the sputtering power supply for the Si target was turned on, and oxygen was supplied at 150 sccm, to deposit a SiO₂ film layer having a thickness of 46.3 nm, thus completing the coating.
g. After the coating was completed, the sputtering power supply for the Si target was turned off, and the power supply for the ion source was turned off. Then, supply of argon and supply of oxygen were turned off, the rotation of the rotating frame was stopped, and after the workpiece was cooled down, a freezer was started to defrost. Finally, air was introduced to the coating chamber so that the pressure in the coating chamber reached atmospheric pressure, and then the coated glass substrate was taken out.

### Example 4

This example is used to describe the ceramic-like structure and the preparation method therefor disclosed in the present disclosure, including most of the steps in Example 1 with the following differences.

### 3) In the coating of the ceramic-like film:

SiO₂ was obtained through coating by sputtering a Si target. Nb₂O₅ was obtained by sputtering a Nb target.
a. The glass substrate was placed on a fixture of a sputtering machine and vacuuming was performed.
b. When a vacuum degree of a coating chamber reached 3×10⁻³ Pa, Ar gas was introduced, and stabilized.
c. An ion source was turned on, supply of oxygen for the ion source was started, and at the same time, a sputtering power supply for a Nb target was turned on with a power of 10 KW, and a thickness was set to 75.3 nm, thus completing the coating of Nb₂O₅.
d. The sputtering power supply for the Nb target was turned off, a sputtering power supply for a Si target was turned on, and oxygen was supplied at 150 sccm, to deposit a SiO₂ film layer having a thickness of 56.3 nm, thus completing the coating.
e. The sputtering power supply for the Si target was turned off, the sputtering power supply for the Nb target was turned on, and oxygen was supplied at 200 sccm, to deposit a Nb₂O₅ film layer having a thickness of 6.2 nm, thus completing the coating.
f. The sputtering power supply for the Nb target was turned off, the sputtering power supply for the Si target was turned on, and oxygen was supplied at 150 sccm, to deposit a SiO₂ film layer having a thickness of 75.1 nm, thus completing the coating.
g. After the coating was completed, the sputtering power supply for the Si target was turned off, and the power supply for the ion source was turned off. Then, supply of argon and supply of oxygen were turned off, the rotation of the rotating frame was stopped, and after the workpiece was cooled down, a freezer was started to defrost. Finally, air was introduced to the coating chamber so that the pressure in the coating chamber reached atmospheric pressure, and then the coated glass substrate was taken out.

### Example 5

This example is used to describe the ceramic-like structure and the preparation method therefor disclosed in the present disclosure, including most of the steps in Example 1 with the following differences.

### 3) In the coating of the ceramic-like film:

SiO₂ was obtained through coating by sputtering a Si target. Nb₂O₅ was obtained by sputtering a Nb target.
a. The glass substrate was placed on a fixture of a sputtering machine and vacuuming was performed.
b. When a vacuum degree of a coating chamber reached 3×10⁻³ Pa, Ar gas was introduced, and stabilized.
c. An ion source was turned on, supply of oxygen for the ion source was started, and at the same time, a sputtering power supply for a Nb target was turned on with a power of 10 KW, and a thickness was set to 26 nm, thus completing the coating of Nb₂O₅.
d. The sputtering power supply for the Nb target was turned off, a sputtering power supply for a Si target was turned on, and oxygen was supplied at 150 sccm, to deposit a SiO₂ film layer having a thickness of 84.4 nm, thus completing the coating.
e. The sputtering power supply for the Si target was turned off, the sputtering power supply for the Nb target was turned on, and oxygen was supplied at 200 sccm, to deposit a Nb₂O₅ film layer having a thickness of 9 nm, thus completing the coating.
f. The sputtering power supply for the Nb target was turned off, the sputtering power supply for the Si target was turned on, and oxygen was supplied at 150 sccm, to deposit a SiO₂ film layer having a thickness of 45.6 nm, thus completing the coating.
g. After the coating was completed, the sputtering power supply for the Si target was turned off, and the power supply for the ion source was turned off. Then, supply of argon and supply of oxygen were turned off, the rotation of the rotating frame was stopped, and after the workpiece was cooled down, a freezer was started to defrost. Finally, air was introduced to the coating chamber so that the pressure in the coating chamber reached atmospheric pressure, and then the coated glass substrate was taken out.

### Example 6

This example is used to describe the ceramic-like structure and the preparation method therefor disclosed in the present disclosure, including most of the steps in Example 1 with the following differences.

### 3) In the coating of the ceramic-like film:

SiO₂ was obtained through coating by sputtering a Si target. Nb₂O₅ was obtained by sputtering a Nb target.
a. The glass substrate was placed on a fixture of a sputtering machine and vacuuming was performed.
b. When a vacuum degree of a coating chamber reached 3×10⁻³ Pa, Ar gas was introduced, and stabilized.
c. An ion source was turned on, supply of oxygen for the ion source was started, and at the same time, a sputtering power supply for a Nb target was turned on with a power of 10 KW, and a thickness was set to 118 nm, thus completing the coating of Nb₂O₅.
d. The sputtering power supply for the Nb target was turned off, a sputtering power supply for a Si target was turned on, and oxygen was supplied at 150 sccm, to deposit a SiO₂ film layer having a thickness of 84.4 nm, thus completing the coating.
e. The sputtering power supply for the Si target was turned off, the sputtering power supply for the Nb target was turned on, and oxygen was supplied at 200 sccm, to deposit a Nb₂O₅ film layer having a thickness of 9 nm, thus completing the coating.
f. The sputtering power supply for the Nb target was turned off, the sputtering power supply for the Si target was turned on, and oxygen was supplied at 150 sccm, to deposit a SiO₂ film layer having a thickness of 45.6 nm, thus completing the coating.
g. After the coating was completed, the sputtering power supply for the Si target was turned off, and the power supply for the ion source was turned off. Then, supply of argon and supply of oxygen were turned off, the rotation of the rotating frame was stopped, and after the workpiece was cooled down, a freezer was started to defrost. Finally, air was introduced to the coating chamber so that the pressure in the coating chamber reached atmospheric pressure, and then the coated glass substrate was taken out.

### Example 7

This example is used to describe the ceramic-like structure and the preparation method therefor disclosed in the present disclosure, including most of the steps in Example 1 with the following differences.

### 3) In the coating of the ceramic-like film:

SiO₂ was obtained through coating by sputtering a Si target. Nb₂O₅ was obtained by sputtering a Nb target.
a. The glass substrate was placed on a fixture of a sputtering machine and vacuuming was performed.
b. When a vacuum degree of a coating chamber reached 3×10⁻³ Pa, Ar gas was introduced, and stabilized.
c. An ion source was turned on, supply of oxygen for the ion source was started, and at the same time, a sputtering power supply for a Nb target was turned on with a power of 10 KW, and a thickness was set to 54.8 nm, thus completing the coating of Nb₂O₅.
d. The sputtering power supply for the Nb target was turned off, a sputtering power supply for a Si target was turned on, and oxygen was supplied at 150 sccm, to deposit a SiO₂ film layer having a thickness of 14 nm, thus completing the coating.
e. The sputtering power supply for the Si target was turned off, the sputtering power supply for the Nb target was turned on, and oxygen was supplied at 200 sccm, to deposit a Nb₂O₅ film layer having a thickness of 9 nm, thus completing the coating.
f. The sputtering power supply for the Nb target was turned off, the sputtering power supply for the Si target was turned on, and oxygen was supplied at 150 sccm, to deposit a SiO₂ film layer having a thickness of 45.6 nm, thus completing the coating.
g. After the coating was completed, the sputtering power supply for the Si target was turned off, and the power supply for the ion source was turned off. Then, supply of argon and supply of oxygen were turned off, the rotation of the rotating frame was stopped, and after the workpiece was cooled down, a freezer was started to defrost. Finally, air was introduced to the coating chamber so that the pressure in the coating chamber reached atmospheric pressure, and then the coated glass substrate was taken out.

### Example 8

This example is used to describe the ceramic-like structure and the preparation method therefor disclosed in the present disclosure, including most of the steps in Example 1 with the following differences.

### 3) In the coating of the ceramic-like film:

SiO₂ was obtained through coating by sputtering a Si target. Nb₂O₅ was obtained by sputtering a Nb target.
a. The glass substrate was placed on a fixture of a sputtering machine and vacuuming was performed.
b. When a vacuum degree of a coating chamber reached 3×10⁻³ Pa, Ar gas was introduced, and stabilized.
c. An ion source was turned on, supply of oxygen for the ion source was started, and at the same time, a sputtering power supply for a Nb target was turned on with a power of 10 KW, and a thickness was set to 54.8 nm, thus completing the coating of Nb₂O₅.
d. The sputtering power supply for the Nb target was turned off, a sputtering power supply for a Si target was turned on, and oxygen was supplied at 150 sccm, to deposit a SiO₂ film layer having a thickness of 97 nm, thus completing the coating.
e. The sputtering power supply for the Si target was turned off, the sputtering power supply for the Nb target was turned on, and oxygen was supplied at 200 sccm, to deposit a Nb₂O₅ film layer having a thickness of 9 nm, thus completing the coating.
f. The sputtering power supply for the Nb target was turned off, the sputtering power supply for the Si target was turned on, and oxygen was supplied at 150 sccm, to deposit a SiO₂ film layer having a thickness of 45.6 nm, thus completing the coating.
g. After the coating was completed, the sputtering power supply for the Si target was turned off, and the power supply for the ion source was turned off. Then, supply of argon and supply of oxygen were turned off, the rotation of the rotating frame was stopped, and after the workpiece was cooled down, a freezer was started to defrost. Finally, air was introduced to the coating chamber so that the pressure in the coating chamber reached atmospheric pressure, and then the coated glass substrate was taken out.

### Example 9

This example is used to describe the ceramic-like structure and the preparation method therefor disclosed in the present disclosure, including most of the steps in Example 1 with the following differences.

### 3) In the coating of the ceramic-like film:

SiO₂ was obtained through coating by sputtering a Si target. Nb₂O₅ was obtained by sputtering a Nb target.
a. The glass substrate was placed on a fixture of a sputtering machine and vacuuming was performed.
b. When a vacuum degree of a coating chamber reached 3×10⁻³ Pa, Ar gas was introduced, and stabilized.
c. An ion source was turned on, supply of oxygen for the ion source was started, and at the same time, a sputtering power supply for a Nb target was turned on with a power of 10 KW, and a thickness was set to 54.8 nm, thus completing the coating of Nb₂O₅.
d. The sputtering power supply for the Nb target was turned off, a sputtering power supply for a Si target was turned on, and oxygen was supplied at 150 sccm, to deposit a SiO₂ film layer having a thickness of 84.4 nm, thus completing the coating.
e. The sputtering power supply for the Si target was turned off, the sputtering power supply for the Nb target was turned on, and oxygen was supplied at 200 sccm, to deposit a Nb₂O₅ film layer having a thickness of 0.5 nm, thus completing the coating.
f. The sputtering power supply for the Nb target was turned off, the sputtering power supply for the Si target was turned on, and oxygen was supplied at 150 sccm, to deposit a SiO₂ film layer having a thickness of 45.6 nm, thus completing the coating.
g. After the coating was completed, the sputtering power supply for the Si target was turned off, and the power supply for the ion source was turned off. Then, supply of argon and supply of oxygen were turned off, the rotation of the rotating frame was stopped, and after the workpiece was cooled down, a freezer was started to defrost. Finally, air was introduced to the coating chamber so that the pressure in the coating chamber reached atmospheric pressure, and then the coated glass substrate was taken out.

### Example 10

This example is used to describe the ceramic-like structure and the preparation method therefor disclosed in the present disclosure, including most of the steps in Example 1 with the following differences.

### 3) In the coating of the ceramic-like film:

SiO₂ was obtained through coating by sputtering a Si target. Nb₂O₅ was obtained by sputtering a Nb target.
a. The glass substrate was placed on a fixture of a sputtering machine and vacuuming was performed.
b. When a vacuum degree of a coating chamber reached 3×10⁻³ Pa, Ar gas was introduced, and stabilized.
c. An ion source was turned on, supply of oxygen for the ion source was started, and at the same time, a sputtering power supply for a Nb target was turned on with a power of 10 KW, and a thickness was set to 54.8 nm, thus completing the coating of Nb₂O₅.
d. The sputtering power supply for the Nb target was turned off, a sputtering power supply for a Si target was turned on, and oxygen was supplied at 150 sccm, to deposit a SiO₂ film layer having a thickness of 84.4 nm, thus completing the coating.
e. The sputtering power supply for the Si target was turned off, the sputtering power supply for the Nb target was turned on, and oxygen was supplied at 200 sccm, to deposit a Nb₂O₅ film layer having a thickness of 38 nm, thus completing the coating.
f. The sputtering power supply for the Nb target was turned off, the sputtering power supply for the Si target was turned on, and oxygen was supplied at 150 sccm, to deposit a SiO₂ film layer having a thickness of 45.6 nm, thus completing the coating.
g. After the coating was completed, the sputtering power supply for the Si target was turned off, and the power supply for the ion source was turned off. Then, supply of argon and supply of oxygen were turned off, the rotation of the rotating frame was stopped, and after the workpiece was cooled down, a freezer was started to defrost. Finally, air was introduced to the coating chamber so that the pressure in the coating chamber reached atmospheric pressure, and then the coated glass substrate was taken out.

### Example 11

This example is used to describe the ceramic-like structure and the preparation method therefor disclosed in the present disclosure, including most of the steps in Example 1 with the following differences.

### 3) In the coating of the ceramic-like film:

SiO₂ was obtained through coating by sputtering a Si target. Nb₂O₅ was obtained by sputtering a Nb target.
a. The glass substrate was placed on a fixture of a sputtering machine and vacuuming was performed.
b. When a vacuum degree of a coating chamber reached 3×10⁻³ Pa, Ar gas was introduced, and stabilized.
c. An ion source was turned on, supply of oxygen for the ion source was started, and at the same time, a sputtering power supply for a Nb target was turned on with a power of 10 KW, and a thickness was set to 54.8 nm, thus completing the coating of Nb₂O₅.
d. The sputtering power supply for the Nb target was turned off, a sputtering power supply for a Si target was turned on, and oxygen was supplied at 150 sccm, to deposit a SiO₂ film layer having a thickness of 84.4 nm, thus completing the coating.
e. The sputtering power supply for the Si target was turned off, the sputtering power supply for the Nb target was turned on, and oxygen was supplied at 200 sccm, to deposit a Nb₂O₅ film layer having a thickness of 9 nm, thus completing the coating.
f. The sputtering power supply for the Nb target was turned off, the sputtering power supply for the Si target was turned on, and oxygen was supplied at 150 sccm, to deposit a SiO₂ film layer having a thickness of 20 nm, thus completing the coating.
g. After the coating was completed, the sputtering power supply for the Si target was turned off, and the power supply for the ion source was turned off. Then, supply of argon and supply of oxygen were turned off, the rotation of the rotating frame was stopped, and after the workpiece was cooled down, a freezer was started to defrost. Finally, air was introduced to the coating chamber so that the pressure in the coating chamber reached atmospheric pressure, and then the coated glass substrate was taken out.

### Example 12

This example is used to describe the ceramic-like structure and the preparation method therefor disclosed in the present disclosure, including most of the steps in Example 1 with the following differences.

### 3) In the coating of the ceramic-like film:

SiO₂ was obtained through coating by sputtering a Si target. Nb₂O₅ was obtained by sputtering a Nb target.
a. The glass substrate was placed on a fixture of a sputtering machine and vacuuming was performed.
b. When a vacuum degree of a coating chamber reached 3×10⁻³ Pa, Ar gas was introduced, and stabilized.
c. An ion source was turned on, supply of oxygen for the ion source was started, and at the same time, a sputtering power supply for a Nb target was turned on with a power of 10 KW, and a thickness was set to 54.8 nm, thus completing the coating of Nb₂O₅.
d. The sputtering power supply for the Nb target was turned off, a sputtering power supply for a Si target was turned on, and oxygen was supplied at 150 sccm, to deposit a SiO₂ film layer having a thickness of 84.4 nm, thus completing the coating.
e. The sputtering power supply for the Si target was turned off, the sputtering power supply for the Nb target was turned on, and oxygen was supplied at 200 sccm, to deposit a Nb₂O₅ film layer having a thickness of 9 nm, thus completing the coating.
f. The sputtering power supply for the Nb target was turned off, the sputtering power supply for the Si target was turned on, and oxygen was supplied at 150 sccm, to deposit a SiO₂ film layer having a thickness of 152 nm, thus completing the coating.
g. After the coating was completed, the sputtering power supply for the Si target was turned off, and the power supply for the ion source was turned off. Then, supply of argon and supply of oxygen were turned off, the rotation of the rotating frame was stopped, and after the workpiece was cooled down, a freezer was started to defrost. Finally, air was introduced to the coating chamber so that the pressure in the coating chamber reached atmospheric pressure, and then the coated glass substrate was taken out.

### Example 13

This example is used to describe the ceramic-like structure and the preparation method therefor disclosed in the present disclosure, including most of the steps in Example 1 with the following differences.

### 3) In the coating of the ceramic-like film:

MgF₂ was obtained by sputtering a MgF₂ film material. Nb₂O₅ is obtained by sputtering a Nb₂O₅ film material.
a. The glass substrate was placed on a fixture of a sputtering machine and vacuuming was performed.
b. When a vacuum degree of a coating chamber reached 3×10⁻³ Pa, Ar gas was introduced, and stabilized.
c. An ion source was turned on, supply of oxygen for the ion source was started, and at the same time, an evaporation power supply for a Nb₂O₅ film material was turned on with a power of 7 KW, and a thickness was set to 66.6 nm, thus completing the coating of Nb₂O₅.
d. The rotating frame was rotated to a MgF₂ film material position to deposit a MgF₂ film layer having a thickness of 58.1 nm, thus completing the coating.
e. The rotating frame was rotated to a Nb₂O₅ film material position, and oxygen was supplied at 40 sccm, to deposit a Nb₂O₅ film layer having a thickness of 9.4 nm, thus completing the coating.
f. The rotating frame was rotated to the MgF₂ film material position to deposit a MgF₂ film layer having a thickness of 38.2 nm, thus completing the coating.
g. After the coating was completed, the evaporation power supply was turned off, and the power supply for the ion source was turned off. Then, supply of argon and supply of oxygen were turned off, the rotation of the rotating frame was stopped, and after the workpiece was cooled down, a freezer was started to defrost. Finally, air was introduced to the coating chamber so that the pressure in the coating chamber reached atmospheric pressure, and then the coated glass substrate was taken out.

### Example 14

This example is used to describe the ceramic-like structure and the preparation method therefor disclosed in the present disclosure, including most of the steps in Example 1 with the following differences.

### 3) In the coating of the ceramic-like film:

SiO₂ was obtained through coating by sputtering a Si target. TiO₂ was obtained by sputtering a Ti target.
a. The glass substrate was placed on a fixture of a sputtering machine and vacuuming was performed.
b. When a vacuum degree of a coating chamber reached 3×10⁻³ Pa, Ar gas was introduced, and stabilized.
c. An ion source was turned on, supply of oxygen for the ion source was started, and at the same time, a sputtering power supply for a Ti target was turned on with a power of 10 KW, and a thickness was set to 56.9 nm, thus completing the coating of TiO₂.
d. The sputtering power supply for the Ti target was turned off, a sputtering power supply for a Si target was turned on, and oxygen was supplied at 150 sccm, to deposit a SiO₂ film layer having a thickness of 38.6 nm, thus completing the coating.
e. The sputtering power supply for the Si target was turned off, the sputtering power supply for the Ti target was turned on, and oxygen was supplied at 200 sccm, to deposit a TiO₂ film layer having a thickness of 3.3 nm, thus completing the coating.
f. The sputtering power supply for the Ti target was turned off, the sputtering power supply for the Si target was turned on, and oxygen was supplied at 150 sccm, to deposit a SiO₂ film layer having a thickness of 122.8 nm, thus completing the coating.
g. After the coating was completed, the sputtering power supply for the Si target was turned off, and the power supply for the ion source was turned off. Then, supply of argon and supply of oxygen were turned off, the rotation of the rotating frame was stopped, and after the workpiece was cooled down, a freezer was started to defrost. Finally, air was introduced to the coating chamber so that the pressure in the coating chamber reached atmospheric pressure, and then the coated glass substrate was taken out.

### Example 15

This example is used to describe the ceramic-like structure and the preparation method therefor disclosed in the present disclosure, including most of the steps in Example 1 with the following difference:
the operation of "coating a drop-resistant layer" was not performed.

### Example 16

This example is used to describe the ceramic-like structure and the preparation method therefor disclosed in the present disclosure, including most of the steps in Example 1 with the following differences.

### 3) In the coating of the ceramic-like film:

a. The glass substrate was placed on a fixture of a sputtering machine and vacuuming was performed.
b. When a vacuum degree of a coating chamber reached 3×10⁻³ Pa, Ar gas was introduced, and stabilized.
c. An ion source was turned on, supply of oxygen for the ion source was started, a sputtering power supply for the Si target was turned on, and oxygen was supplied at 150 sccm, to deposit a SiO₂ film layer having a thickness of 45.6 nm, thus completing the coating.
d. The sputtering power supply for the Si target was turned off, a sputtering power supply for the Nb target was turned on, and oxygen was supplied at 200 sccm, to deposit a Nb₂O₅ film layer having a thickness of 9 nm, thus completing the coating.
e. The sputtering power supply for the Nb target was turned off, the sputtering power supply for the Si target was turned on, and oxygen was supplied at 150 sccm, to deposit a SiO₂ film layer having a thickness of 84.4 nm, thus completing the coating.
f. The sputtering power supply for the Si target was turned off, the sputtering power supply for the Nb target was turned on, and oxygen was supplied at 200 sccm, to deposit a Nb₂O₅ film layer having a thickness of 54.8 nm, thus completing the coating.
g. After the coating was completed, the sputtering power supply for the Nb target was turned off, and the power supply for the ion source was turned off. Then, supply of argon and supply of oxygen were turned off, the rotation of the rotating frame was stopped, and after the workpiece was cooled down, a freezer was started to defrost. Finally, air was introduced to the coating chamber so that the pressure in the coating chamber reached atmospheric pressure, and then the coated glass substrate was taken out.

### Comparative Example 1

This comparative example provides a black ceramic structure.

### Comparative Example 2

This comparative example is used to describe the ceramic-like structure and the preparation method therefor disclosed in the present disclosure, including most of the steps in Example 1 with the following differences.

### 3) In the coating of the ceramic-like film:

SiO₂ was obtained through coating by sputtering a Si target. Nb₂O₅ was obtained by sputtering a Nb target.
a. The glass substrate was placed on a fixture of a sputtering machine and vacuuming was performed.
b. When a vacuum degree of a coating chamber reached 3×10⁻³ Pa, Ar gas was introduced, and stabilized.
c. An ion source was turned on, supply of oxygen for the ion source was started, and at the same time, a sputtering power supply for a Nb target was turned on with a power of 10 KW, and a thickness was set to 54.8 nm, thus completing the coating of Nb₂O₅.
d. The sputtering power supply for the Nb target was turned off, a sputtering power supply for a Si target was turned on, and oxygen was supplied at 150 sccm, to deposit a SiO₂ film layer having a thickness of 84.4 nm, thus completing the coating.
e. The sputtering power supply for the Si target was turned off, the sputtering power supply for the Nb target was turned on, and oxygen was supplied at 200 sccm, to deposit a Nb₂O₅ film layer having a thickness of 9 nm, thus completing the coating.
g. After the coating was completed, the sputtering power supply for the Nb target was turned off, and the power supply for the ion source was turned off. Then, supply of argon and supply of oxygen were turned off, the rotation of the rotating frame was stopped, and after the workpiece was cooled down, a freezer was started to defrost. Finally, air was introduced to the coating chamber so that the pressure in the coating chamber reached atmospheric pressure, and then the coated glass substrate was taken out.

### Comparative Example 3

This comparative example is used to describe the ceramic-like structure and the preparation method therefor disclosed in the present disclosure, including most of the steps in Example 1 with the following differences.

### 3) In the coating of the ceramic-like film:

SiO₂ was obtained through coating by sputtering a Si target. Nb₂O₅ was obtained by sputtering a Nb target.
a. The glass substrate was placed on a fixture of a sputtering machine and vacuuming was performed.
b. When a vacuum degree of a coating chamber reached 3×10⁻³ Pa, Ar gas was introduced, and stabilized.
c. An ion source was turned on, supply of oxygen for the ion source was started, and at the same time, a sputtering power supply for a Nb target was turned on with a power of 10 KW, and a thickness was set to 54.8 nm, thus completing the coating of Nb₂O₅.
d. The sputtering power supply for the Nb target was turned off, a sputtering power supply for a Si target was turned on, and oxygen was supplied at 150 sccm, to deposit a SiO₂ film layer having a thickness of 84.4 nm, thus completing the coating.
e. The sputtering power supply for the Si target was turned off, the sputtering power supply for the Nb target was turned on, and oxygen was supplied at 200 sccm, to deposit a Nb₂O₅ film layer having a thickness of 9 nm, thus completing the coating.
f. The sputtering power supply for the Nb target was turned off, the sputtering power supply for the Si target was turned on, and oxygen was supplied at 150 sccm, to deposit a SiO₂ film layer having a thickness of 45.6 nm, thus completing the coating.
f. The sputtering power supply for the Si target was turned off, the sputtering power supply for the Nb target was turned on, and oxygen was supplied at 200 sccm, to deposit a Nb₂O₅ film layer having a thickness of 36 nm, thus completing the coating.
h. After the coating was completed, the sputtering power supply for the Nb target was turned off, and the power supply for the ion source was turned off. Then, supply of argon and supply of oxygen were turned off, the rotation of the rotating frame was stopped, and after the workpiece was cooled down, a freezer was started to defrost. Finally, air was introduced to the coating chamber so that the pressure in the coating chamber reached atmospheric pressure, and then the coated glass substrate was taken out.

### Comparative Example 4

This comparative example is used to describe the ceramic-like structure and the preparation method therefor disclosed in the present disclosure, including most of the steps in Example 1 with the following differences.

### 3) In the coating of the ceramic-like film:

Al₂O₃ was obtained through coating by sputtering an Al target. SiO₂ was obtained through coating by sputtering a Si target. Nb₂O₅ was obtained by sputtering a Nb target.
a. The glass substrate was placed on a fixture of a sputtering machine and vacuuming was performed.
b. When a vacuum degree of a coating chamber reached 3×10⁻³ Pa, Ar gas was introduced, and stabilized.
c. An ion source was turned on, supply of oxygen for the ion source was started, and at the same time, a sputtering power supply for an Al target was turned on with a power of 10 KW, and a thickness was to 46 nm, thus completing the coating of Al₂O₃.
d. The sputtering power supply for the Al target was turned off, a sputtering power supply for a Nb target was turned on, and oxygen was supplied at 200 sccm, to deposit a Nb₂O₅ film layer having a thickness of 54.8 nm, thus completing the coating.
e. The sputtering power supply for the Nb target was turned off, a sputtering power supply for a Si target was turned on, and oxygen was supplied at 150 sccm, to deposit a SiO₂ film layer having a thickness of 84.4 nm, thus completing the coating.
f. The sputtering power supply for the Si target was turned off, the sputtering power supply for the Nb target was turned on, and oxygen was supplied at 200 sccm, to deposit a Nb₂O₅ film layer having a thickness of 9 nm, thus completing the coating.
g. The sputtering power supply for the Nb target was turned off, the sputtering power supply for the Si target was turned on, and oxygen was supplied at 150 sccm, to deposit a SiO₂ film layer having a thickness of 45.6 nm, thus completing the coating.
h. After the coating was completed, the sputtering power supply for the Si target was turned off, and the power supply for the ion source was turned off. Then, supply of argon and supply of oxygen were turned off, the rotation of the rotating frame was stopped, and after the workpiece was cooled down, a freezer was started to defrost. Finally, air was introduced to the coating chamber so that the pressure in the coating chamber reached atmospheric pressure, and then the coated glass substrate was taken out.

### Performance Test

1. The following tests were carried out on the ceramic-like structures prepared in Examples 1 to 16 and Comparative Example 2 to 4 and the real ceramic structure provided in Comparative Example 1.
   1.1. Lab color detection: Lab color detection under different angles of incidence of light was carried out on the ceramic-like structures prepared in Examples 1 to 16 and Comparative Example 2 to 4 and the real ceramic structure provided in Comparative Example 1 by using a colorimeter. L, a, and b respectively represent L, a, and b values in the Lab color space. The L value represents lightness. A larger L value indicates a higher lightness (or a whiter color). A smaller L value indicates a lower lightness (or a darker color). The L value may range from 0 to 100. The value represents a color value. A positive a value represents red, and a larger a value indicates a redder color. A negative a value represents green, and a smaller a value indicates a greener color. The value ranges from -120 to 120. The b value represents a color value. A positive b value represents yellow, and a larger b value indicates a yellower color. A negative b value represents blue, and a smaller b value indicates a bluer color. The b value ranges from -120 to 120.
   1.2. Reflectivity test: The reflectivity test was carried out on the ceramic-like structures prepared in Examples 1 to 16 and Comparative Example 2 to 4 and the real ceramic structure provided in Comparative Example 1 by using a UV-2800 spectrophotometer from Shimadzu, Japan. Parameter setting of the UV-2800 spectrophotometer was as follows.
      1) Spectral width: 4 nm
      2) Wavelength range: 190 nm - 1100 nm
      3) Wavelength accuracy: ± 0.5 nm
      4) Wavelength repeatability: 0.3 nm
      5) Wavelength resolution: 0.1 nm

The test results are shown in Table 1.

**Table 1**

| Angle of incidence | | 0° | 20° | 40° | 60° | 80° | Reflectivity |
|---|---|---|---|---|---|---|---|
| Color value of Example 1 | L | 49.4 | 49.4 | 49.8 | 53.1 | 72.16 | 27.3% |
| | a | -0.49 | -0.47 | -0.57 | -0.71 | -0.24 | |
| | b | -0.64 | -0.43 | 0.17 | 0.6 | 0.18 | |
| Color value of Example 2 | L | 49.82 | 49.77 | 50.06 | 53.24 | 72.19 | 28% |
| | a | -0.94 | -0.83 | -0.70 | -0.68 | -0.22 | |
| | b | -0.35 | -0.28 | 0.12 | 0.53 | 0.27 | |
| Color value of Example 3 | L | 49.29 | 49.29 | 49.72 | 53.08 | 72.16 | 26.4 |
| | a | -0.52 | -0.50 | -0.58 | -0.71 | -0.24 | |
| | b | 0.32 | 0.41 | 0.74 | 0.95 | 0.49 | |
| Color value of Example 4 | L | 49.5 | 49.5 | 49.8 | 53.1 | 72.1 | 27.5 |
| | a | -0.59 | -0.58 | -0.67 | -0.77 | -0.25 | |
| | b | -0.74 | -0.56 | 0.53 | 086 | 0.36 | |
| Color value of Example 5 | L | 49.41 | 49.36 | 49.67 | 52.92 | 72.10 | 27.8 |
| | a | -0.28 | -0.31 | -0.50 | -0.70 | -0.24 | |
| | b | -3.6 | -3.3 | -2.3 | -1.2 | -0.28 | |
| Color value of Example 6 | L | 48.45 | 48.52 | 49.14 | 52.76 | 72.10 | 26.1% |
| | a | -0.64 | -0.58 | -0.56 | -0.64 | -0.22 | |
| | b | 4.55 | 4.55 | 4.54 | 3.75 | 0.94 | |
| Color value of Example 7 | L | 48.60 | 48.69 | 49.37 | 52.95 | 72.15 | 26.2% |
| | a | -0.22 | -0.32 | -0.66 | -0.90 | -0.29 | |
| | b | 2.06 | 2.29 | 2.66 | 2.24 | 0.53 | |
| Color value of Example 8 | L | 51.53 | 51.34 | 51.25 | 53.89 | 72.31 | 29.3% |
| | a | -2.10 | -1.80 | -1.30 | -0.80 | -0.22 | |
| | b | -2.00 | -2.30 | -2.50 | -1.80 | -0.44 | |
| Color value of Example 9 | L | 49.85 | 49.90 | 50.42 | 53.69 | 72.33 | 27.5% |
| | a | -0.70 | -0.74 | -0.92 | -1.0 | -0.33 | |
| | b | 1.27 | 1.38 | 1.58 | 1.32 | 0.29 | |
| Color value of Example 10 | L | 48.83 | 48.73 | 48.97 | 52.33 | 71.95 | 27.1% |
| | a | -0.28 | -0.18 | -0.13 | -0.28 | -0.12 | |
| | b | -3.2 | -2.9 | -1.9 | -0.55 | -0.01 | |
| Color value of Example 11 | L | 50.47 | 50.36 | 50.44 | 53.29 | 72.15 | 28% |
| | a | -1.8 | -1.7 | -1.5 | -1.2 | -0.30 | |
| | b | -0.03 | -0.24 | -0.6 | -0.64 | -0.17 | |
| Color value of Example 12 | L | 48.61 | 48.53 | 48.89 | 52.50 | 72.05 | 27% |
| | a | -0.12 | -0.11 | 0.33 | 0.02 | -0.09 | |
| | b | -3.4 | -3.0 | -1.6 | 0.22 | 0.25 | |
| Color value of Example 13 | L | 49.66 | 49.57 | 49.71 | 52.71 | 71.97 | 27.7% |
| | a | -0.15 | -0.20 | -0.40 | -0.54 | -0.16 | |
| | b | -0.61 | -0.34 | 0.33 | 0.83 | 0.29 | |
| Color value of Example 14 | L | 49.55 | 49.74 | 50.66 | 54.31 | 72.6 | 27.5% |
| | a | -0.26 | -0.39 | -0.86 | -0.97 | -0.47 | |
| | b | -0.66 | -0.30 | -0.47 | 0.57 | 0.01 | |
| Color value of Example 15 | L | 49.24 | 49.24 | 49.68 | 53.05 | 72.15 | 27.1% |
| | a | -0.49 | -0.47 | -0.55 | -0.69 | -0.24 | |
| | b | -0.05 | 0.13 | 0.66 | 0.95 | 0.26 | |
| Color value of Example 16 | L | 49.27 | 49.26 | 49.68 | 53.03 | 72.14 | 27.2% |
| | a | -0.44 | -0.43 | -0.53 | -0.69 | -0.24 | |
| | b | -0.64 | -0.41 | 0.24 | 0.69 | 0.21 | |
| Color value of Comparative Example 1 | L | 49.7 | 49.8 | 50.8 | 52.1 | 71.9 | 27.4% |
| | a | 0.17 | -0.01 | 0.07 | -0.03 | -0.05 | |
| | b | -1.20 | -0.29 | -0.34 | -0.36 | -0.03 | |
| Color value of Comparative Example 2 | L | 50.04 | 49.71 | 49.28 | 51.96 | 71.76 | 27.8% |
| | a | -2.10 | -1.80 | -1.20 | -0.62 | -0.11 | |
| | b | -5.00 | -5.10 | -5.10 | -3.60 | -0.77 | |
| Color value of Comparative Example 3 | L | 63.65 | 65.08 | 67.71 | 69.21 | 77.57 | 36.2% |
| | a | -0.90 | -4.30 | -9.50 | -9.40 | -3.70 | |
| | b | 49.88 | 49.08 | 35.42 | 13.92 | 1.72 | |
| Color value of Comparative Example 4 | L | 45.22 | 45.40 | 46.41 | 50.87 | 71.68 | 24.1% |
| | a | 0.45 | 0.42 | 0.23 | -0.14 | -0.10 | |
| | b | 4.40 | 4.61 | 5.03 | 4.21 | 0.98 | |

From the test results in Table 1, it can be seen that the color values of the ceramic-like structures prepared by the preparation method provided by the present disclosure are similar to those of the real ceramic structure of Comparative Example 1 at different angles of incidence of light, and the light reflectivity of the ceramic-like structures prepared by the preparation method provided by the present disclosure is also close to that of the real ceramic structure of Comparative Example 1, indicating that the ceramic-like structure provided by the present disclosure has no obvious color difference from the real ceramic when viewed from different angles, and achieves a good ceramic-like effect.

From the test results of Examples 1 to 4 and Examples 5 to 12, it can be seen that when the thicknesses of the first high-refractive-index material layer, the second high-refractive-index material layer, the first low-refractive-index material layer, and the second low-refractive-index material layer are respectively within the ranges defined in the present disclosure, the ceramic-like effect can be further improved.

From the test results of Comparative Examples 1 to 4, it can be seen that a change in the number of ceramic-like film layers or in the order of ceramic-like film layers in the stack leads to a large difference in the color of the ceramic-like structure, and the ceramic-like structure has a significant color difference from real ceramics especially at different angles of incidence of light, and has a problem of color change.

2. An impact resistance test was carried out for the ceramic-like structures prepared in Examples 1 to 4 and Example 15 and a glass substrate having not been subjected to any treatment. The test conditions were: dropping a 110 g ball from a height of 5 cm to impact four R angles of the ceramic-like structure or glass substrate, each point being impacted 5 times, and if the ceramic-like structure or glass substrate is not broken, increasing the height by another 5 cm, and repeating the drop ball impact according to the above method, until the ceramic-like structure or glass substrate is broken, and recording the height. The test results are shown in Table 2.

**Table 2**

| Test scheme | Drop ball test/cm | | | | | | | | | |
|---|---|---|---|---|---|---|---|---|---|---|
| | Sample 1 | Sample 2 | Sample 3 | Sample 4 | Sample 5 | Sample 6 | Sample 7 | Sample 8 | Sample 9 | Sample 10 |
| Glass substrate | 35 | 40 | 40 | 35 | 40 | 45 | 40 | 45 | 40 | 45 |
| Example 1 | 40 | 40 | 40 | 45 | 40 | 40 | 35 | 40 | 45 | 40 |
| Example 2 | 40 | 35 | 40 | 40 | 40 | 35 | 40 | 45 | 40 | 45 |
| Example 3 | 40 | 40 | 35 | 40 | 45 | 40 | 45 | 40 | 40 | 40 |
| Example 4 | 40 | 45 | 40 | 40 | 35 | 45 | 40 | 40 | 45 | 40 |
| Example 15 | 5 | 10 | 15 | 10 | 10 | 10 | 15 | 10 | 10 | 10 |

It can be seen from the test results in Table 2 that the arrangement of the drop-resistant layer between the glass substrate and the ceramic-like film layer, the problem that the impact resistance of the glass substrate is reduced due to the stress generated by the ceramic-like film layer can be effectively avoided, and the drop-resistant performance of the ceramic-like structure can be improved.

3. The following tests were carried out on the ceramic-like structures prepared in Examples 1 and 16.

### A. Conditions for boiling and cross-cut tests:

1) An appropriate amount of pure water was added to a constant-temperature water tank and heated to the boiling temperature of 100 °C. Then, the product was put into the constant-temperature water tank. The product should not contact the wall of the boiling water tank. The product was taken out after boiling for 1 hour.
2) After drying with a dust-free cloth, the product was left to stand at room temperature for at least 2 hours. The appearance of the product was observed and compared with that of a normal sample.
3) Cross-cut: A grid of 10×10 squares of 1 mm×1 mm was cut in the surface area using a sharp blade. All cuts scratched the glass. A 3M610 adhesive tape was adhered to the cross-cut area. Air between the adhesive tape and the cross-cut area was squeezed out. The adhesive tape was statically pressed for 5 seconds or more. With the product being held still, the adhesive tape was quickly pulled perpendicular to the surface from one side. The process was repeated 3 times.

Test criteria: The adhesion should not be lower than 4B, there should be no abnormality in appearance, and there should be no coating layer and ink layer flaking off.

### B. High-temperature and high-humidity test conditions:

1) Temperature: 65±1°C; humidity: 91-95%RH; test time: 96H.
2) The product was taken out after a time specified in the experiment was reached. The product was left to stand under natural conditions for at least 2 hours. The appearance of the product was observed and compared with that of a normal sample.
3) Cross-cut: A grid of 10×10 squares of 2 mm×2 mm was cut in the surface area using a sharp blade. All cuts scratched the glass. A 3M610 adhesive tape was adhered to the cross-cut area. Air between the adhesive tape and the cross-cut area was squeezed out. The adhesive tape was statically pressed for 5 seconds or more. With the product being held still, the adhesive tape was quickly pulled perpendicular to the surface from one side. The process was repeated 3 times.

Test criteria: The adhesion should not be lower than 4B, there should be no abnormality in appearance, and there should be no coating layer and ink layer flaking off.

### C: Cosmetic test condition:

1) The surface of the product was first wiped clean with a cotton cloth. NIVEA sunscreen oil (SPF30) and NIVEA hand cream were applied to the front side of the product. Each type of cosmetic was applied to two samples. It should be noted that the edge and pores of the product should be applied with more cosmetic than other areas of the product.
2) Temperature: 55±1°C; humidity: 93±2%RH; test time: 96H.
3) The product was taken out after a time specified in the experiment was reached. The product was left to stand under natural conditions for at least 2 hours. The appearance of the product was observed and compared with that of a normal sample. 4) Cross-cut: A 3M610 adhesive tape was adhered to the ink surface. Air between the adhesive tape and the cross-cut area was squeezed out. The adhesive tape was statically pressed for 5 seconds or more. With the product being held still, the adhesive tape was quickly pulled perpendicular to the surface from one side. The process was repeated 3 times.

Test criteria: The adhesion should not be lower than 4B, there should be no abnormality in appearance, and there should be no coating layer and ink layer flaking off.

### D. Artificial sweat test conditions:

1) A solution was formulated according to the "Artificial Sweat Formulation Guide", PH=4.6±0.1.
2) A dust-free cloth soaked with the solution was attached to the surface of the sample, sealed with a sealed plastic bag, and stored in a constant-temperature and constant-humidity chamber for a time specified in the experiment (temperature: 55±1°C; humidity: 93±2%RH; test time: 96H.)
3) The appearance of the product was observed and compared with that of a normal sample.
4) Cross-cut: A grid of 10×10 squares of 2 mm×2 mm was cut in the surface area using a sharp blade. All cuts scratched the glass. A 3M610 adhesive tape was adhered to the ink surface. Air between the adhesive tape and the cross-cut area was squeezed out. The adhesive tape was statically pressed for 5 seconds or more. With the product being held still, the adhesive tape was quickly pulled perpendicular to the surface from one side. The process was repeated 3 times.

Test criteria: The adhesion should not be lower than 4B, there should be no abnormality in appearance, and there should be no coating layer and ink layer flaking off.

The test results are shown in Table 3.

**Table 3**

| Test scheme | Boiling and cross-cut tests | High-temperature and high-humidity 96H | Cosmetics 96H | Artificial sweat 96H |
|---|---|---|---|---|
| Example 1 | 5B | 5B | 5B | 5B |
| Example 16 | 4B | 3B | 3B | 4B |

From the test results, it can be seen that compared with the stacking of the first high-refractive-index material layer, the first low-refractive-index material layer, the second high-refractive-index material layer, and the second low-refractive-index material layer in sequence in the direction away from the transparent substrate, the stacking of the first high-refractive-index material layer, the first low-refractive-index material layer, the second high-refractive-index material layer, and the second low-refractive-index material layer in sequence in the direction away from the transparent substrate can effectively increase the bonding force between the film layers and the transparent substrate and ink layer.

The foregoing descriptions are merely preferred examples of the present disclosure, but are not intended to limit the present disclosure. Any modification, equivalent replacement, or improvement made within the spirit and principle of the present disclosure shall fall within the protection scope of the present disclosure.

## Claims

1. A ceramic-like structure, comprising:
a transparent substrate (1);
an ink layer (4); and
a ceramic-like film layer (3), the ceramic-like film layer (3) being located between the transparent substrate (1) and the ink layer (4), the ceramic-like film layer (3) being formed by a first high-refractive-index material layer (31), a first low-refractive-index material layer (32), a second high-refractive-index material layer (33), and a second low-refractive-index material layer (34), and the first high-refractive-index material layer (31), the first low-refractive-index material layer (32), the second high-refractive-index material layer (33), and the second low-refractive-index material layer (34) being stacked in sequence; and
refractive indexes of the first high-refractive-index material layer (31) and the second high-refractive-index material layer (33) being greater than 2.3, and refractive indexes of the first low-refractive-index material layer (32) and the second low-refractive-index material layer (34) being less than 1.6.

2. The ceramic-like structure according to claim 1, wherein a reflectivity of the ceramic-like structure ranges from 25% to 30%.

3. The ceramic-like structure according to any one of claims 1 to 2, wherein the first high-refractive-index material layer (31) is in contact with the transparent substrate (1).

4. The ceramic-like structure according to any one of claims 1 to 3, wherein the first low-refractive-index material layer (32) and the second low-refractive-index material layer (34) are each independently selected from at least one of SiO₂ and MgF₂.

5. The ceramic-like structure according to claim 4, wherein the first low-refractive-index material layer (32) and the second low-refractive-index material layer (34) are selected from SiO₂.

6. The ceramic-like structure according to any one of claims 1 to 5, wherein the first high-refractive-index material layer (31) and the second high-refractive-index material layer (33) are each independently selected from at least one of Nb₂O₅, Ti₃O₅, and TiO₂.

7. The ceramic-like structure according to claim 6, wherein the first high-refractive-index material layer (31) and the second high-refractive-index material layer (33) are selected from Nb₂O₅.

8. The ceramic-like structure according to any one of claims 1 to 7, wherein a thickness of the first high-refractive-index material layer (31) ranges from 53.8 nm to 105.8 nm, a thickness of the second high-refractive-index material layer (33) ranges from 1 nm to 16 nm, a thickness of the first low-refractive-index material layer (32) ranges from 32.4 nm to 86.4 nm, and a thickness of the second low-refractive-index material layer (34) ranges from 44.6 nm to 90.6 nm.

9. The ceramic-like structure according to any one of claims 1 to 8, wherein the transparent substrate (1) is glass.

10. The ceramic-like structure according to any one of claims 1 to 9, further comprising a drop-resistant layer (2), the drop-resistant layer (2) is located between the transparent substrate (1) and the ceramic-like film layer (3), and the drop-resistant layer (2) is an organosiloxane material.

11. The ceramic-like structure according to claim 10, wherein the organosiloxane material is obtained by polymerization of a low-molecular-weight siloxane, the low-molecular-weight siloxane comprises at least one of a dialkoxysilane containing an organic group, a trialkoxysilane containing an organic group, and a tetraalkoxysilane, and the organic group is selected from the group consisting of an alkyl group, a phenyl group, an epoxy group, an amino group, an isocyanate group, an ester group, and combinations thereof.

12. The ceramic-like structure according to claim 10, wherein a thickness of the drop-resistant layer (2) ranges from 100 nm to 2000 nm.

13. A method for preparing the ceramic-like structure according to any one of claims 1 to 12, comprising:
providing a transparent precursor comprising the transparent substrate (1);
coating the first high-refractive-index material layer (31), the first low-refractive-index material layer (32), the second high-refractive-index material layer (33), and the second low-refractive-index material layer (34) on the transparent precursor in sequence to form the ceramic-like film layer (3) on a surface of the transparent precursor; and
applying an ink to a surface of the formed ceramic-like film layer (3) to obtain the ceramic-like structure.

14. The method for preparing the ceramic-like structure according to claim 13, wherein a surface of the transparent substrate (1) is covered with a silicate-based material to form a drop-resistant layer (2) to obtain the transparent precursor; and the ceramic-like film layer (3) is formed on a surface of the drop-resistant layer (2).

15. The method for preparing the ceramic-like structure according to any one of claims 13 to 14, wherein before the drop-resistant layer (2) is formed, the transparent substrate (1) is subjected to surface cleaning treatment.

16. The method for preparing the ceramic-like structure according to any one of claims 13 to 15, wherein the first high-refractive-index material layer (31), the first low-refractive-index material layer (32), the second high-refractive-index material layer (33), and the second low-refractive-index material layer (34) are coated on the transparent precursor in sequence by vacuum coating.

17. An electronic device housing, comprising the ceramic-like structure according to any one of claims 1 to 12.
